# EUROPEAN PATENT APPLICATION

(11) **EP 3 437 793 A1**
(43) Date of publication of application: **06.02.2019**
(21) Application number: 17774662.5
(22) Date of filing: 23.03.2017
(51) Int. Cl.: B23Q 3/08, B05C 13/00, B65H 23/02, H01G 13/00, H01M 10/04

(54) **SHEET JIG, STAGE, MANUFACTURING DEVICE, AND METHOD FOR MANUFACTURING SECONDARY BATTERY**

(30) Priority: 28.03.2016 JP 2016063451
(71) Applicant: Kabushiki Kaisha Nihon Micronics, Musashino-shi Tokyo 1808508 (JP)
(72) Inventor: KIMURA Katsuhiko, Musashino-shi Tokyo 180-8508 (JP); MIZOE Yoshiaki, Musashino-shi Tokyo 180-8508 (JP); SAITO Tomokazu, Musashino-shi Tokyo 180-8508 (JP); DEWA Harutada, Musashino-shi Tokyo 180-8508 (JP)
(74) Representative: Regi, François-Xavier
(86) International application number: PCT/JP2017/011722
(87) International publication number: WO 2017/170124

(57) **Abstract**

A sheet jig of the present invention includes a center placement face (17) on which a center region of a sheet (50) is placed as having a plurality of first air holes (13) to cause the center region of the sheet (50) to be stuck, a peripheral upper face (18) formed outside the center placement face (17) at height being lower than the center placement face (17) as having a plurality of second air holes (14) to cause a peripheral region of the sheet (50) to be stuck, and a slope face (19) formed from the center placement face (17) to the peripheral upper face (18).

## Description

### Technical Field

The present invention relates to a jig, a stage, a manufacturing apparatus, and a method for manufacturing a secondary cell.

### Background Art

Patent Document 1 discloses a recording medium having excellent adhesiveness between a toner sheet and an image-receiving sheet. Here, a plurality of suction holes are arranged at the image-receiving sheet along a drum rotating direction. The image-receiving sheet is attached so that the suction holes thereof are overlapped with suction holes of a rotating drum for recording. Then, the toner sheet is stuck and intimately contacted to the image-receiving sheet through the suction holes of the image-receiving sheet and the suction holes of the rotating drum for recording (paragraph 0041). Further, Patent Document 1 discloses in paragraph 0045 that the suction holes may be formed at four sides of the image-receiving sheet.

### Citation List

### Patent Literature

Patent Document 1: Japanese Unexamined Patent Application Publication No. H11-277920

### Summary of Invention

### Technical Problem

In some cases of manufacturing electronic components, a variety of manufacturing processes such as a film-forming process and a machining process have been performed on a sheet that is stuck to a sheet jig. Such manufacturing processes are preferably performed in a state that the sheet has no wrinkle. For example, owing to that a film-forming process is performed on a sheet in a state that the sheet has no wrinkle (i.e., that the sheet is flat), thickness of the film formed into a sheet shape can be approximately uniformed. Accordingly, it has been desired to develop a technology capable of flattening a sheet before a manufacturing process is performed thereon.

In view of the above, an object of the present invention is to provide a technology capable of flattening a sheet before a manufacturing process is performed on the sheet.

### Solution to Problem

A sheet jig according to an aspect of the present embodiment includes a center placement face on which a center region of a sheet is placed as having a plurality of first air holes configured to cause the center region of the sheet to be stuck, a peripheral upper face formed outside the center placement face at height being lower than the center placement face in side view as having a plurality of second air holes configured to cause a periphery region of the sheet to be stuck, and a slope face formed from the center placement face to the peripheral upper face. According to the above, appearance of wrinkles and folds can be prevented and the sheet can be flattened.

In the above sheet jig, a boundary between the peripheral upper face and the slope face may be chamfered. Accordingly, appearance of wrinkles can be further suppressed.

In the above sheet jig, the second air hole may have a diameter-increasing portion at which diameter thereof increases toward the peripheral upper face from the lower side in side view. Accordingly, appearance of wrinkles can be further suppressed.

In the above sheet jig, a boundary between the second air hole and the peripheral upper face may be chamfered. Accordingly, appearance of wrinkles can be further suppressed.

In the above sheet jig, the second air hole may be adjacent to the slope face. Accordingly, appearance of wrinkles can be further suppressed.

A stage according to an aspect of the present embodiment includes the abovementioned sheet jig, and an air discharging mechanism configured to discharge air downward from an upper face of the sheet jig through the first air holes and the second air holes. According to the above, appearance of wrinkles and folds can be prevented and the sheet can be flattened.

A manufacturing apparatus according to an aspect of the present embodiment includes the abovementioned stage and performs a manufacturing process on the sheet in a state that the sheet is stuck to the stage.

In the above manufacturing apparatus, the manufacturing process may include at least either a film-forming process to form a film on the sheet or a machining process to process the sheet.

The above manufacturing apparatus may include a pair of conveying reels including a winding reel configured to wind the sheet and a feeding reel configured to feed the sheet onto the sheet jig, and an air supplying mechanism configured to release stick of the sheet to the stage by supplying air toward an upper face of the sheet jig through the first air holes and the second air holes.

The above manufacturing apparatus may include a first valve connected to the air discharging mechanism, a second valve connected to the air supplying mechanism, and a controller configured to control the air discharging mechanism to perform air discharging in a state that the pair of conveying reels are stopped and the sheet is pulled in a feeding direction.

In the above manufacturing apparatus, the controller may be configured to control the first valve and the second valve so that discharging with the air discharging mechanism, stick releasing of the sheet with the air supplying mechanism, and discharging with the air discharging mechanism are performed in the order thereof.

A method for manufacturing a sheet-shaped secondary cell according to an aspect of the present embodiment may include a manufacturing process for the sheet-shaped secondary cell to be performed on a sheet using the abovementioned manufacturing apparatus.

In the method for manufacturing a sheet-shaped secondary cell, the manufacturing process may include at least placing the sheet as a first electrode, and layering an n-type metal oxide semiconductor layer formed of n-type metal oxide semiconductor and a charge layer formed of material including n-type metal oxide semiconductor and insulting material, on the sheet in the order thereof.

### Advantageous Effects of Invention

According to the present invention, it is possible to provide a technology capable of flattening a sheet before a manufacturing process is performed on the sheet.

### Brief Description of Drawings

FIG. 1 is a perspective view illustrating a structure of a stage of a first embodiment;
FIG. 2 is a top view illustrating a structure of a sheet jig of the first embodiment;
FIG. 3 is an exploded perspective view illustrating the structure of the sheet jig of the first embodiment;
FIG. 4 is a sectional view at IV-IV in FIG. 2;
FIG. 5 is a sectional view at V-V in FIG. 2;
FIG. 6 is a top view illustrating the stage with a sheet placed thereon;
FIG. 7 is a sectional view at VII-VII in FIG. 6;
FIG. 8 is a sectional view illustrating a boundary region between a center placement face and a peripheral upper face;
FIG. 9 is a sectional view illustrating the boundary region with a sheet placed thereon;
FIG. 10 is an enlarged sectional view illustrating the boundary region of the sheet jig;
FIG. 11 is a view for explaining stick operation of the stage of the first embodiment;
FIG. 12 is a top view schematically illustrating a structure of a sheet jig of a first comparison example;
FIG. 13 is a sectional view illustrating the structure of the sheet jig of the first comparison example;
FIG. 14 is a top view schematically illustrating a structure of a sheet jig of a second comparison example;
FIG. 15 is a sectional view illustrating the structure of the sheet jig of the second comparison example;
FIG. 16 is a view illustrating a structure of a manufacturing apparatus using a stage of the second embodiment;
FIG. 17 is a view illustrating the structure of the manufacturing apparatus using the stage of the second embodiment;
FIG. 18 is a view for explaining stick operation of the stage of the second embodiment; and
FIG. 19 is a view for explaining a sticking process of the stage of the second embodiment.

### Description of Embodiments

In the following, examples of embodiments of the present invention will be described with reference to the drawings. The description in the following is simply for preferable embodiments and is not intended to limit the scope of the present invention to the following embodiments.

### <First embodiment>

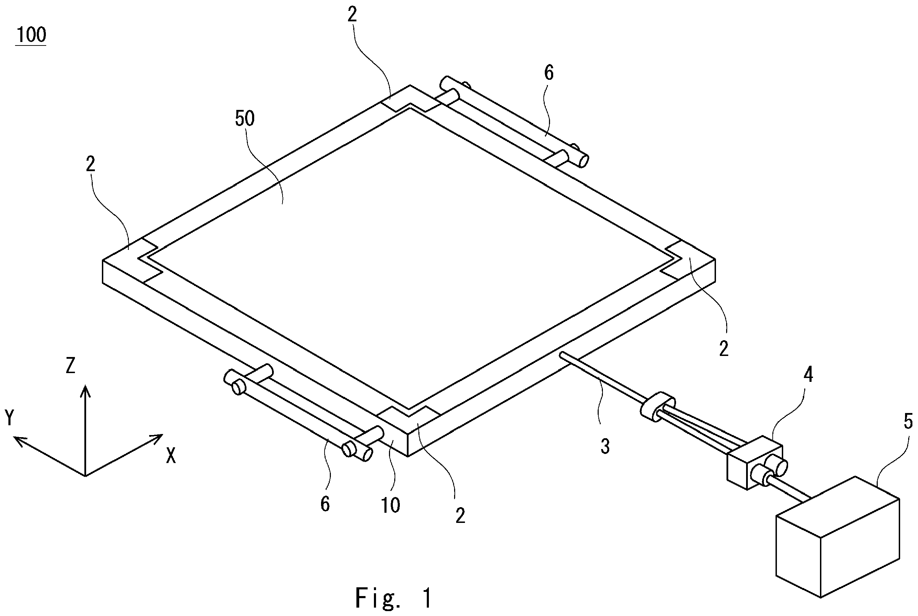

A sheet jig and a stage of the present embodiment will be described with reference to FIG. 1. FIG. 1 is a perspective view schematically illustrating a structure of a stage. For clarifying description, an XYZ three-dimensional orthogonal coordinate system is illustrated in the drawings. Z direction is a thickness direction of a sheet 50 being a target to be stuck and released and X direction and Y direction are directions on a sheet plane. A stage 100 includes a sheet jig 10, a positioning guide 2, a pipe 3, a valve 4, and a vacuum pump 5.

The sheet jig 10 is a rectangular plate-shaped member with sides thereof oriented along X direction and Y direction. An upper face of the sheet jig 10 is a stick-release face of a sheet. Air holes for sticking and releasing a sheet are formed on the upper face of the sheet jig 10.

The positioning guides 2 are arranged on the upper face of the sheet jig 10 respectively in the vicinities of four corners of the sheet jig 10 that is rectangular in top view. The positioning guides 2 perform positioning of a sheet to be placed on the stage 100. Owing to that four corners of a sheet are matched to the positioning guides 2 manually or automatically, the sheet is placed on the sheet jig 10 at an appropriate position.

The pipe 3 is connected to a side face of the sheet jig 10. The pipe 3 is connected to the vacuum pump 5 through the valve 4. The vacuum pump 5 serves as an air discharging mechanism to generate negative pressure for sticking a sheet. The vacuum pump 5 discharges air downward from the upper face of the sheet jig 10 through later-described first air holes 13 and second air holes 14. The vacuum pump 5 generates negative pressure of -60kPa, for example. When the valve 4 is opened, the vacuum pump 5 discharges air inside the sheet jig 10 through the pipe 3. Accordingly, a sheet 50 placed on the upper face of the sheet jig 10 is stuck and held. When the valve 4 is closed, stick of the sheet 50 can be released. Here, two valves 4 may be arranged separately to perform sticking of the sheet 50 with one valve 4 and releasing thereof with the other valve 4.

Grip portions 6 are arranged respectively on two opposed side faces of the sheet jig 10. Owing to that the grip portions 6 are held by a user, the sheet jig 10 can be moved easily.

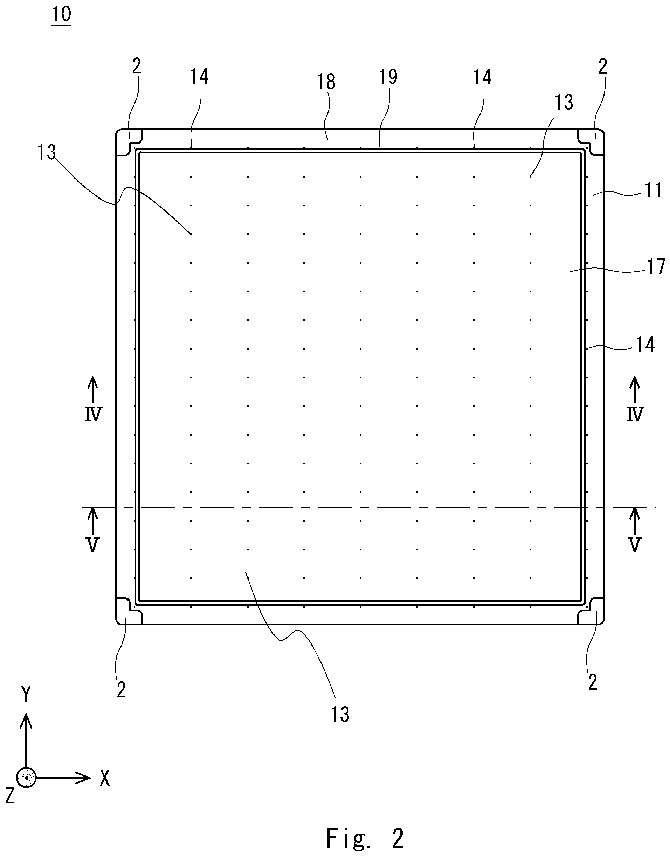

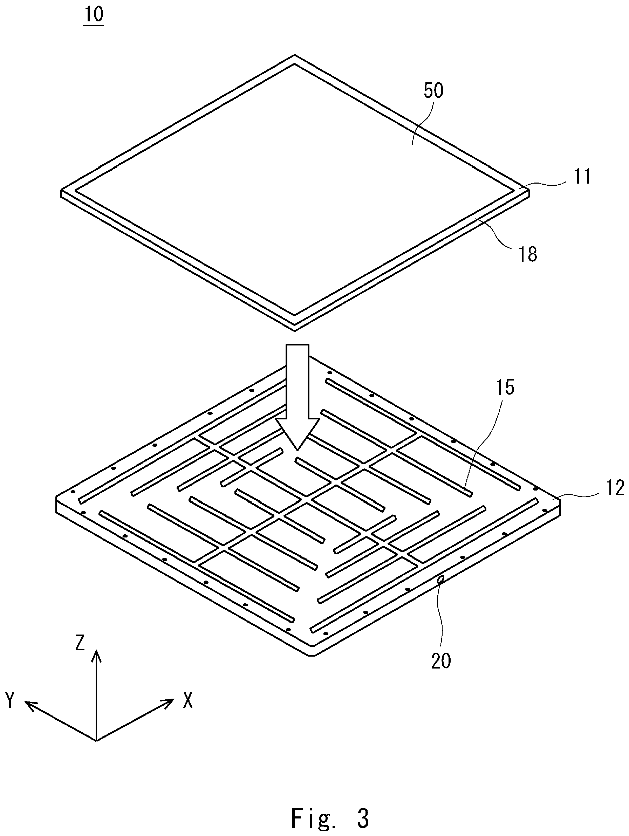

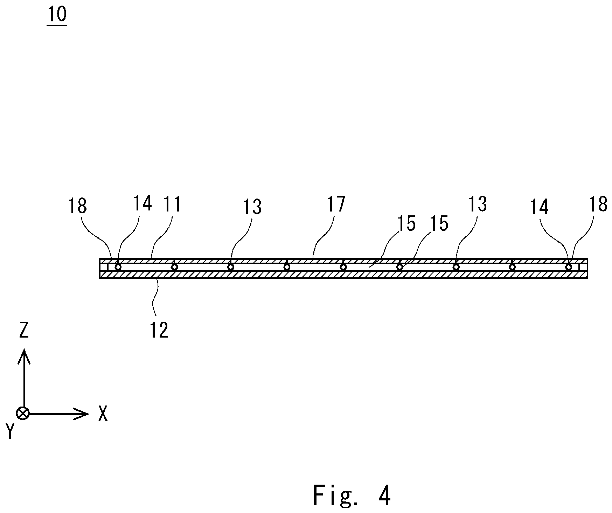

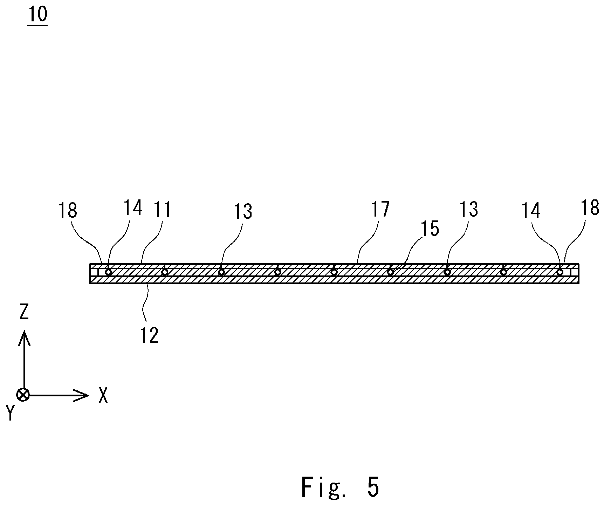

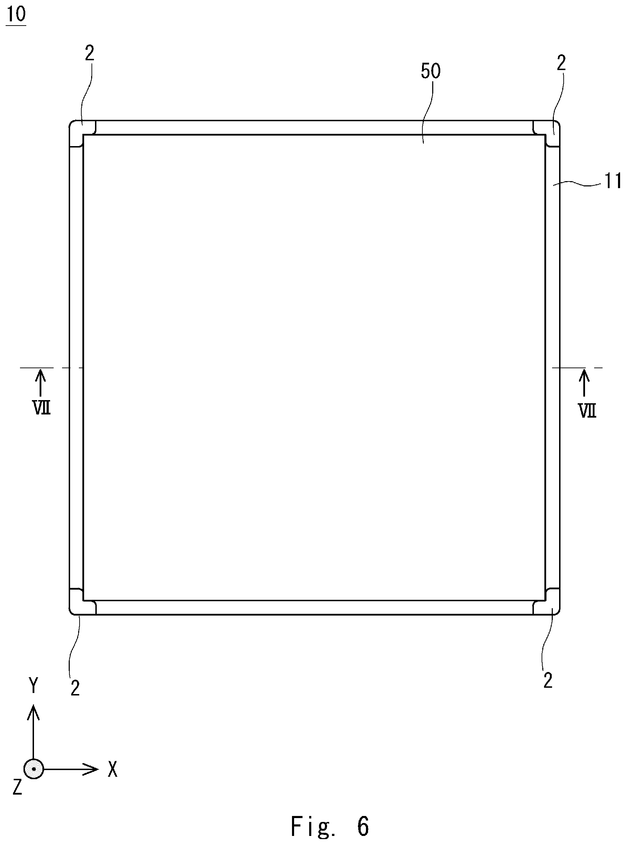

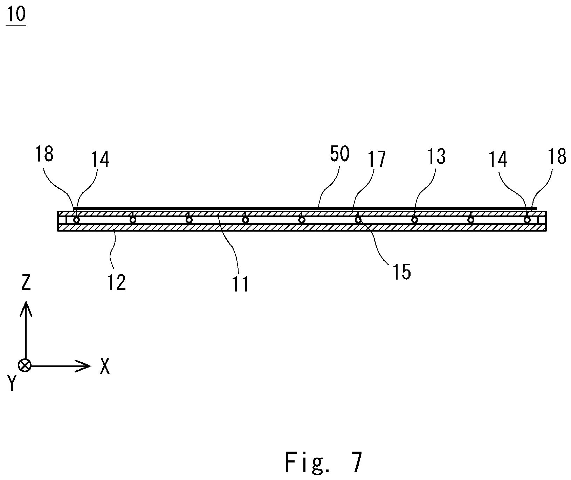

Next, a structure of the sheet jig 10 will be described in detail with reference to FIGs. 2 to 7. FIG. 2 is a top view illustrating the structure of the sheet jig 10. FIG. 3 is an exploded perspective view illustrating the structure of the sheet jig 10. FIG. 4 is a sectional view at IV-IV in FIG. 2. FIG. 5 is a sectional view at V-V in FIG. 2. FIG. 6 is a top view illustrating the structure with a sheet 50 placed thereon. FIG. 7 is a sectional view at VII-VII in FIG. 6.

As illustrated in FIG. 2, the sheet jig 10 is a rectangular member in a top view (XY plane view). The sheet jig 10 includes a center placement face 17 and a peripheral upper face 18. That is, the upper face of the sheet jig 10 is separated into the center placement face 17 and the peripheral upper face 18. The center placement face 17 corresponds to a rectangular region at the center of the sheet jig 10. The peripheral upper face 18 corresponds to a rectangular frame-shaped region outside the center placement face 17.

The sheet 50 to be stuck and released is larger than the center placement face 17. That is, the sheet 50 protrudes from the center placement face 17. The center region of the sheet 50 is placed on the center placement face 17 and the end region of the sheet 50 is placed on the peripheral upper face 18. The sheet 50 is rectangular, for example, being 320 mm in both vertical and horizontal length. For example, the sheet 50 is a metal foil of SUS, aluminum, or the like being 10 um in thickness. The sheet 50 may be a resin sheet of polyimide, polyethylene terephthalate (PET), or the like.

A plurality of the first air holes 13 are formed at the center placement face 17. The first air holes 13 are arranged in a matrix manner. The first air holes 13 are arranged at regular intervals in both X direction and Y direction. Specifically, 15 pieces of the first air holes 13 are arranged in Y direction at 20 mm intervals and 7 pieces thereof are arranged in X direction at 40 mm intervals. Thus, 105 pieces of the first air holes 13 are arranged at the center placement face 17.

A plurality of the second air holes 14 are formed at the peripheral upper face 18. The second air holes 14 are arranged along the rectangular frame-shaped peripheral upper face 18. Specifically, 17 pieces of the second air holes 18 are arranged in Y direction at 20 mm intervals and 9 pieces thereof are arranged in X direction at 40 mm intervals . Thus, 48 pieces of the second air holes 14 are arranged at the peripheral upper face 18. Each second air hole 14 has a circular shape with a hole diameter of 0.5 mm.

Thus, the first air holes 13 are formed at the center placement face 17 and the second air holes 14 are formed at the peripheral upper face 18. Accordingly, the center placement face 17 and the peripheral upper face 18 serve as the stick-release face of the sheet 50. The sheet 50 is placed above the first air holes 13 and the second air holes 14. That is, the sheet 50 covers the first air holes 13 and the second air holes 14 (see FIG. 6). Here, not limited to the values described above, intervals, numbers, and size of the first air holes 13 and the second air holes 14 may be changed appropriately.

As illustrated in FIGs. 3 to 5, the sheet jig 10 includes a base plate 12 and a plate 11. The plate 11 and the base plate 12 are rectangular plate-shaped members made of, for example, aluminum array. Being made of aluminum array, the sheet jig 10 is lightened to be easily carried around. Here, the base plate 12 and the plate 11 may be arranged integrally.

The plate 11 and the base plate 12 are arranged to face to each other. The plate 11 is arranged on the base plate 12 so that the plate 11 and the base plate 12 are overlapped to each other. The plate 11 is fixed to the base plate 12 with screws or the like. The first air holes 13 and the second air holes 14 penetrate through the plate 11 in Z direction.

An air hole groove 15 is formed at the base plate 12. The air hole groove 15 is extended in X direction and Y direction. The air hole groove 15 is arranged right below all the first air holes 13 and the second air holes 14. Accordingly, the air hole groove 15 is in communication with all the first air holes 13 and the second air holes 14. Although the sheet jig 10 is structured with two plates being the plate 11 and the base plate 12 in the example of FIG. 3, the sheet jig 10 may be structured with a single plate. Such sheet jig 10 may be obtained, for example, by forming the air hole groove 15 and the like inside the single plate.

The air hole groove 15 is in communication with a piping hole 20 formed at a side face of the base plate 12 (see FIG. 3). The pipe 3 illustrated in FIG. 1 is connected to the piping hole 20. The vacuum pump 5 illustrated in FIG. 1 discharges air in the air hole groove 15 through the piping hole 20. Accordingly, negative pressure occurs at the first air holes 13 and the second air holes 14, so that the sheet 50 is stuck (see FIG. 7). For releasing stick of the sheet 50, air is supplied to the air hole groove 15 through the piping hole 20. Thus, the piping hole 20 serves as a discharging hole for discharging air and a supplying hole for supplying air. Similarly, the air hole groove 15 serves as a discharging groove for discharging air and a supplying groove for supplying air.

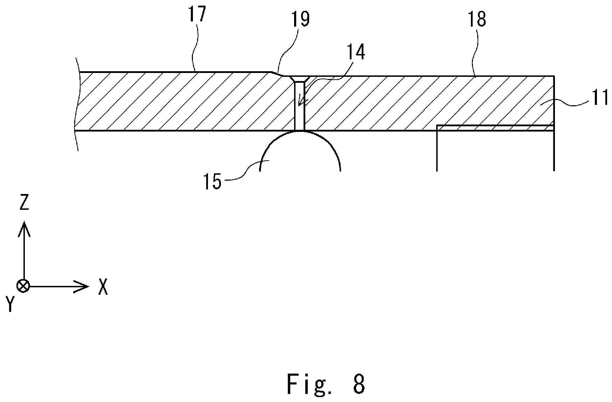

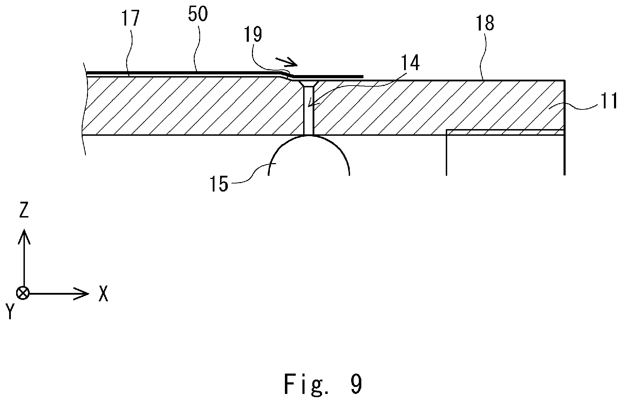

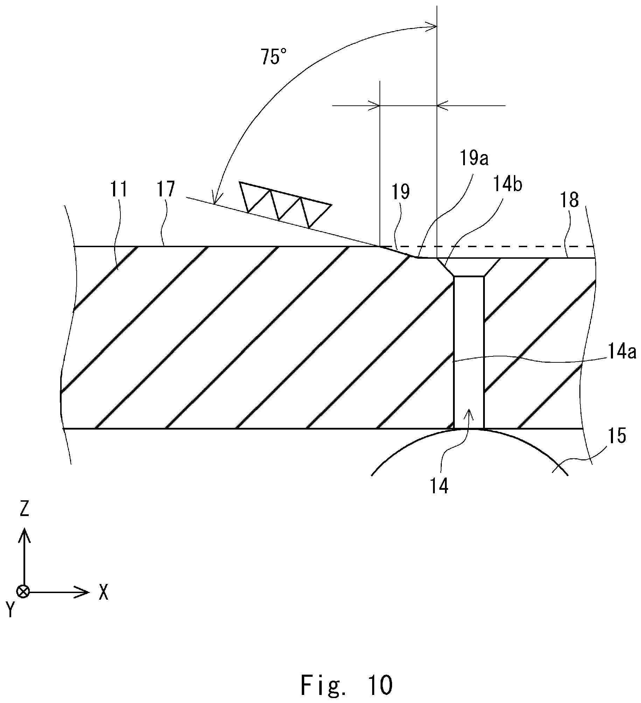

In the following, description will be provided on a structure at a boundary region between the center placement face 17 and the peripheral upper face 18 with reference to FIGs. 8 to 10. FIGs. 8 and 9 are sectional views illustrating the structure at the boundary region between the center placement face 17 and the peripheral upper face 18. FIG. 10 is an enlarged sectional view illustrating the structure at the boundary region. FIGs. 8 and 10 illustrate a state in which the sheet 50 is not placed on the sheet jig 10. FIG. 9 illustrates a state in which the sheet 50 is placed on the sheet jig 10.

Each of the center placement face 17 and the peripheral upper face 18 is in parallel to the XY plane. The peripheral upper face 18 is set lower than the center placement face 17. Accordingly, an uneven region is formed at the boundary region between the center placement face 17 and the peripheral upper face 18. A slope face 19 is formed at the uneven region. The slope face 19 is not in parallel to the XY plane. It is preferable that the slope face 19 is formed seamlessly at the boundary region between the center placement face 17 and the peripheral upper face 18. Here, the slope face 19 is formed as a continuous rectangular frame shape in XY plane view.

The slope face 19 is formed from the center placement face 17 to the peripheral upper face 18. The slope face 19 is decline toward the peripheral upper face 18 from the center placement face 17. Owing to that the slope face 19 is arranged between the center placement face 17 and the peripheral upper face 18 having different heights, the center placement face 17 and the peripheral upper face 18 are connected smoothly. The slope face 19 is a smoothly-finished surface.

Owing to that the slope face 19 is arranged between the center placement face 17 and the peripheral upper face 18, force to pull outward is exerted on the sheet 50. Force to pull the sheet 50 outward along the slope face 19 is exerted as indicated by an arrow in FIG. 9 and wrinkles fade away. That is, tensile force exerted on end regions of the sheets 50 causes wrinkles to fade away. Thus, the sheet jig 10 can cause the sheet 50 to be flattened while suppressing appearance of wrinkles.

The angle between the slope face 19 and the XY plane is 15 degrees, that is, the angle between the slope face 19 and Z direction is 75 degrees, as illustrated in FIG. 10. The center placement face 17 is higher than the peripheral upper face 18 by 0.2 mm. Accordingly, height difference between the center placement face 17 and the peripheral upper face 18 is larger than the thickness of the sheet 50. The end region of the sheets 50 is stuck at a position lower than the center region thereof.

Further, as illustrated in FIG. 10, a chamfer portion 19a is formed at an end of the slope face 19 on the side of the peripheral upper face 18. The chamfer portion 19a has a round-chamfered shape. Here, the end of the slope face 19 on the side of the peripheral upper face 18 is chamfered at R2. Owing to that the boundary between the slope face 19 and the peripheral upper face 18 is round chamfered, appearance of wrinkles of the sheet 50 can suppressed effectively. The round chamfering at the boundary between the slope face 19 and the peripheral upper face 18 produces space between the slope face 19 and the sheet 50, so that tension of the sheet 50 can be stabilized. Accordingly, the sheet jig 10 can cause the sheet 50 to be flattened while suppressing appearance of wrinkles.

As described above, the space between the slope face 19 and the sheet 50 is necessary for stabilizing tension of the sheet 50, so that curvature formed at the slope face 19 is a key factor. When the chamfer portion 19a is straight or swelled upward, tension force on the sheet 50 is lessened. In the present embodiment, since the chamfer portion 19a is arranged at the outer end of the slope face 19, tension of the sheet 50 can be stabilized.

A taper portion 14b of 45 degrees is arranged at an upper end of each of the second air holes 14. At the taper portion 14b, the hole diameter of the second air hole 14 gradually decreases toward the lower side from the peripheral upper face 18. In other words, the taper portion 14b is a diameter-increasing portion at which the hole diameter increases toward the peripheral upper face 18 from the lower side. A straight portion 14a having the constant hole diameter is arranged below the taper portion 14b. The straight portion 14a is cylindrical with a diameter of 0.5 mm. The upper end of the taper portion 14b is circular with a diameter of 1 mm. The taper portion 14b enlarges area of the second air hole 14. Accordingly, stick force can be enlarged and appearance of wrinkles can be suppressed. The length of the slope face 19 in X direction including the chamfer portion 19a is about 1 mm. The distance from the end of the center placement face 17 to the end of the taper portion 14b in X direction is about 1 mm. Here, round chamfering is performed on the boundary between the second air hole 14 and the peripheral upper face 18.

The second air holes 14 are arranged adjacent to the slope face 19 beside positions where the slope of the slope face 19 is ended. That is, the second air holes 14 are in contact with the slope face 19. Specifically, the end of each second air hole 14 is in contact with the end of the taper portion 19a of the slope face 19. According to the above, appropriate tensile force can be exerted on the sheet 50 and appearance of wrinkles can be suppressed.

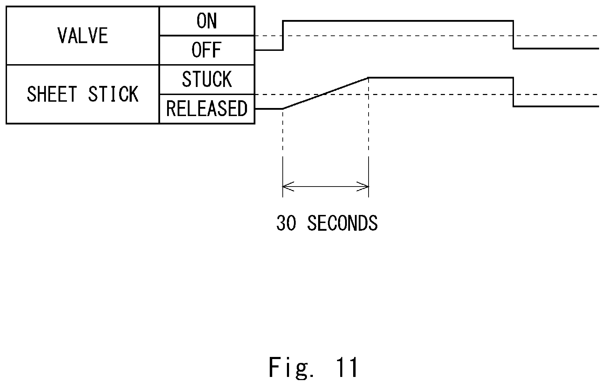

Next, description will be provided on operation of the valve 4 for causing the sheet 50 to be stuck with reference to FIG. 11. FIG. 11 is a time chart indicating stick operation and release operation of the valve 4 for the sheet 50. When the valve 4 is turned on, negative pressure occurs at the center placement face 17 and the peripheral upper face 18 and sticking of the sheet 50 starts. Then, the sheet 50 is to be stuck to the sheet jig 10 in about 30 seconds. When sticking starts after the valve 4 is opened, winkles of the sheet 50 are gradually reduced. The winkles disappear in 30 seconds. After the wrinkles disappear, a predetermined manufacturing process is performed on the sheet 50. When the valve 4 is turned off, the stick is released.

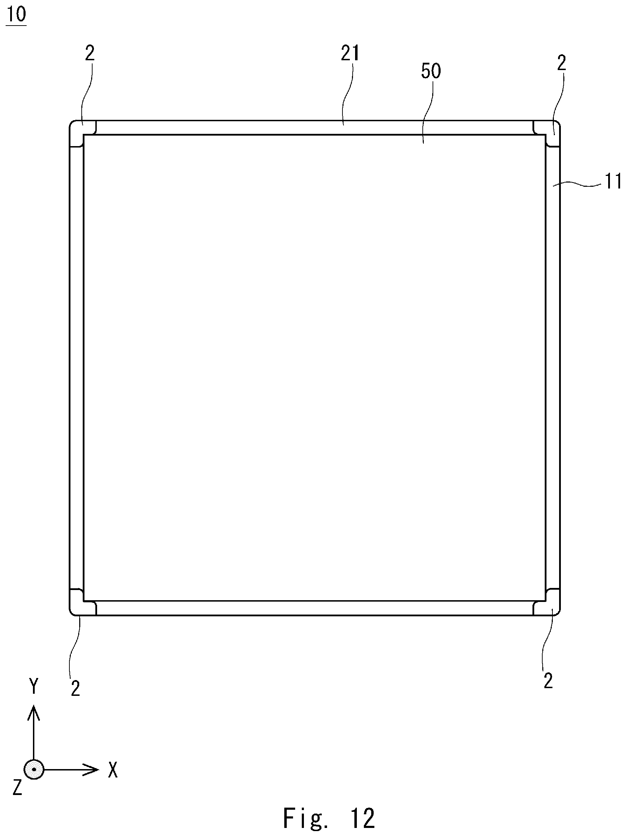

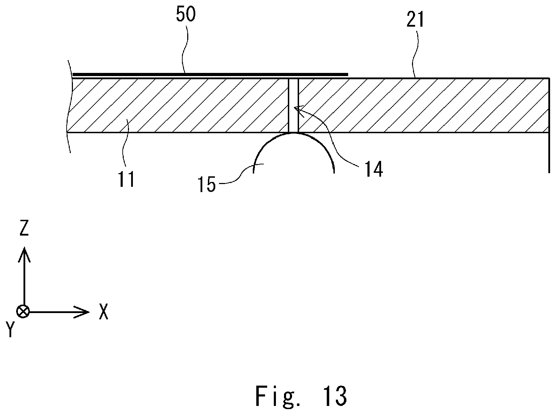

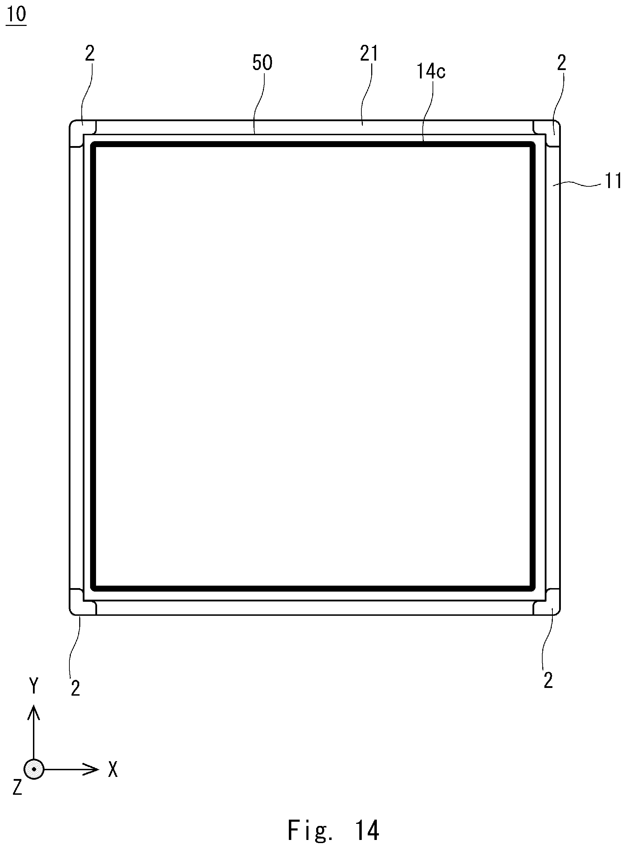

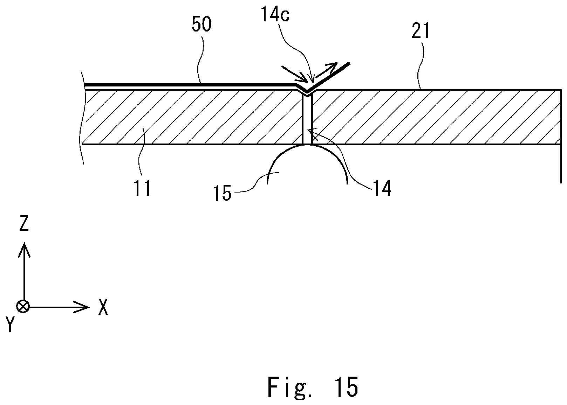

Next, description will be provided on structures of first and second comparison examples with reference to FIGs. 12 to 15. FIG. 12 is an XY plane view schematically illustrating a structure of a sheet jig 10 of the first comparison example. FIG. 13 is a sectional view illustrating the structure of the sheet jig 10 of the first comparison example. FIG.14 is an XY plane view schematically illustrating a sheet jig 10 of the second comparison example. FIG. 15 is a sectional view illustrating the structure of the sheet jig 10 of the second comparison example. Each of FIGs. 13 and 15 illustrates a structure right below an end region of the sheet 50.

In the first comparison example, a placement face 21 is even as illustrated in FIG. 13. That is, the periphery upper face 18 lower than the center placement face 17 is not arranged in the first comparison example. In this case, since force to pull the sheet 50 outward does not exist, wrinkles are apt to remain.

In the second comparison example, a periphery groove 14c is formed as a V-shaped groove at upper ends of the second air holes 14 as illustrated in FIG. 15. As illustrated in FIG. 14, the periphery groove 14c is formed continuously into a rectangular frame shape in XY plane view. In the second comparison example, since tension force to pull the sheet 50 outward is exerted along the downward slope of the periphery groove 14c, wrinkles are reduced. However, the sheet 50 is folded along the upward slope of the periphery groove 14c. Accordingly, folds occur at the end region of the sheet 50 along the V-shaped face of the periphery groove 14c right above the periphery groove 14c.

In contrast, in the sheet jig 10 of the present embodiment, an uneven region is formed between the center placement face 17 and the periphery upper face 18 and the slope face 19 is formed at the uneven region. According to the above, tension force is exerted on the sheet 50 and appearance of wrinkles and folds can be prevented. Accordingly, the sheet 50 can be flattened.

The stage 100 is built into a variety of manufacturing apparatuses. In a manufacturing apparatus, a manufacturing process is performed on the sheet 50 stuck and fixed to the sheet jig 10. For example, in a manufacturing process of a secondary cell, application liquid is applied on the sheet 50 placed on the sheet jig 10. That is, an applying unit applies application liquid onto the sheet 50 stuck to the sheet jig 10. Specifically, the applying unit applies application liquid with slit coating. Since wrinkles do not exist, application liquid can be applied evenly on the surface of the sheet 50. In a manufacturing process of a secondary cell, for example, application liquid corresponding to a charge layer can be applied to the secondary cell. Accordingly, productivity of secondary cells can be improved.

The manufacturing process of a sheet-shaped secondary cell includes a process of placing a sheet as a first electrode and a process of layering an n-type metal oxide semiconductor layer formed of n-type metal oxide semiconductor and a charge layer formed of material including n-type metal oxide semiconductor and insulting material, on the sheet in the order thereof.

### <Second embodiment>

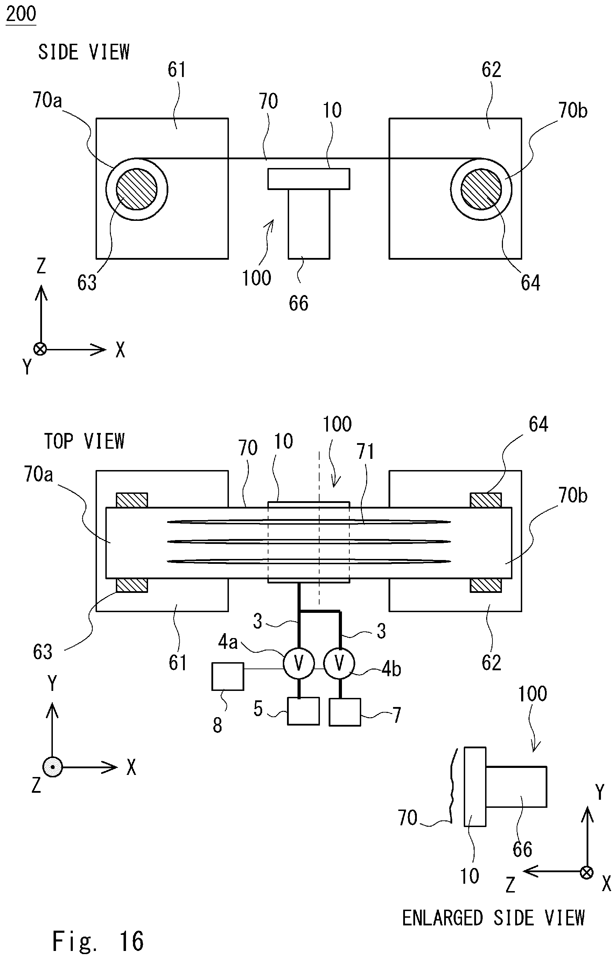

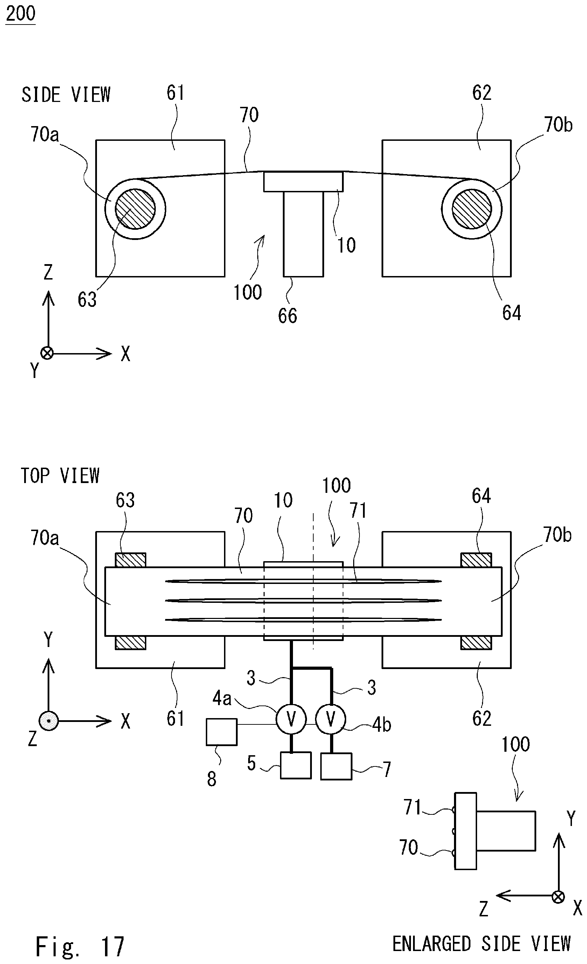

A manufacturing apparatus using the sheet jig 10 of the present embodiment will be described with reference to FIGs. 16 and 17. In the present embodiment, a sheet 70 tension-routed between a pair of conveying reels is stuck to a sheet jig 10. FIG. 16 illustrates a waiting state before the sheet 70 is stuck. FIG. 17 illustrates a stuck state after the sheet 70 is stuck to the sheet jig 10. Each of FIGs. 16 and 17 includes a side view of a manufacturing apparatus 200, an XY plane view of a main part thereof, and a schematic enlarged sectional view thereof.

Since the basic structure of the sheet jig 10 is the same as the first embodiment, description thereof is appropriately skipped. For example, in the sheet jig 10, the slope face 19 is arranged between the center placement face 17 and the peripheral upper face 18. The sheet 70 is a SUS sheet having width of 350 mm in Y direction and thickness of 10 um. In the present embodiment, intervals and the number of air holes are different from the first embodiment. Specifically, 11 pieces of the first air holes 13 are arranged in Y direction at 20 mm intervals and 7 pieces thereof are arranged in X direction at 40 mm intervals. Further, 13 pieces of the second air holes 14 are arranged in Y direction at 20 mm intervals and 9 pieces thereof are arranged in X direction at 40 mm intervals. Here, size of the first air holes 13 and the second air holes 14 is the same as the first embodiment. The plate 11 and the base plate 12 are formed of carbon steel and low-temperature black chromium processing is performed thereon.

The manufacturing apparatus 200 includes a feeding unit 61 and a winding unit 62. The sheet jig 10 is arranged between the feeding unit 61 and the winging unit 62 in X direction. A feeding reel 63 is rotatably attached to the feeding unit 61. Similarly, a winding reel 64 is rotatably attached to the winding unit 62. Each of the feeding reel 63 and the winding reel 64 are rotated by an unillustrated motor or the like. The sheet 70 wound to the feeding reel 63 is called a feeding roll 70a and the sheet 70 wound to the winding reel 64 is called a wound roll 70b.

In the present embodiment, the slope face 19 is required to be formed at the boundary between the center placement face 17 and the peripheral upper face 18 only in a feeding direction of the sheet 70 (X direction). That is, the slope face 19 is only required to be formed at both sides in X direction not at both sides in Y direction.

The feeding reel 63 and the winding reel 64 serve as conveying reels to feed the roll-shaped sheet 70 onto the sheet jig 10. The sheet 70 is conveyed in +X direction by synchronized rotation of the feeding reel 63 and the winding reel 64. The sheet 70 of the feeding roll 70a is moved to the winding roll 70b as passing over the sheet jig 10. Thus, the sheet 70 is tension-routed over the sheet jig 10.

The sheet jig 10 is attached to a lifting-lowering mechanism 66. The lifting-lowering mechanism 66 moves the sheet jig 10 vertically (in Z direction). The sheet jig 10 supported by the lifting-lowering mechanism 66 is moved between a sticking position and a waiting position. That is, when the lifting-lowering mechanism 66 moves upward the sheet jig 10, the sheet jig 10 is located at the sticking position at which the sheet 70 is stuck (see FIG. 17). At that time, the sheet 70 tension-routed between the feeding unit 61 and the winding unit 62 is contacted to the sheet jig 10 and lifted thereby. When the lifting-lowering mechanism 66 moves the sheet jig 10 downward, the sheet jig 10 is located at the waiting position at which the sheet 70 is not stuck (see FIG. 16). Since the center placement face 17 of the sheet jig 10 is lower than the sheet 70 at the waiting position, the sheet 70 is not in contact with the sheet jig 10. At the waiting position, the sheet 70 is fed by the feeding reel 63 and the winding reel 64.

A pipe 3 is connected to the sheet jig 10. The pipe 3 is separated into two lines to which valves 4a, 4b are connected respectively. A vacuum pump 5 is connected to one valve 4a and an air supplying mechanism 7 is connected to the other valve 4b. The air supplying mechanism 7 includes a gas cylinder, regulator, and the like to supply air for stick releasing. A controller 8 performs ON-OFF control of the valves 4a, 4b to open and close the valves 4a, 4b respectively at appropriate timing. The controller 8 controls the vacuum pump 5 to perform air discharging in a state that the sheet 70 is pulled in the feeding direction with the feeding reel 63 and the winding reel 64 stopped.

As described above, for sticking the sheet 70, the valve 4b is closed and the valve 4a is opened. Then, the vacuum pump 5 discharges air through the first air holes 13 and the second air holes 14 of the sheet jig 10 and the pipe 3. Accordingly, the sheet 70 is stuck and fixed to the sheet jig 10. On the contrary, for stick releasing of the sheet 70, the valve 4b is opened and the valve 4a is closed. Then, the air supplying mechanism 7 supplies air to the sheet jig 10 through the pipe 3. Accordingly, pressure at the first air holes 13 and the second air holes 14 becomes positive and stick of the sheet 70 is released. The air supplying mechanism 7 supplies air toward the upper face of the sheet jig 10 through the first air holes 13 and the second air holes 14 to release stick of the sheet 70 to the stage 100.

In the present embodiment, since tensile force is exerted on the sheets 70, deflection due to the tensile force occurs at the sheet 70 in the width direction of the sheet 70, that is, in Y direction. Owing to the deflection, wrinkles 71 appear along X direction over the sheet jig 10. When extending to an end region of the sheet jig 10, the wrinkles 71 appear across the slope face 19 illustrated in FIG. 9. Accordingly, space is apt to occur between the sheet 70 and the sheet jig 10 at the end region in X direction. When space occurs at lateral ends of the sheet jig 10, sticking cannot be appropriately performed and the wrinkles 71 are apt to remain during sticking.

In the present embodiment, sticking with the valve 4a turned on is performed two times. That is, sticking with the valve 4a turned on, stick releasing with the valve 4b turned on, and sticking with the valve 4a turned on are performed sequentially. The controller 8 controls the valves 4a, 4b so that sticking with vacuum and stick releasing are performed repeatedly. That is, the controller 8 controls the valves 4a, 4b so that discharging with the vacuum pump 5, stick releasing with the air supplying mechanism 7, and discharging with vacuum pump 5 are sequentially performed in a state that the feeding reel 63 and the winding reel 64 remain stopped. For sticking, the valve 4a is opened and the valve 4b is closed. For stick releasing, the valve 4b is opened and the valve 4a is closed.

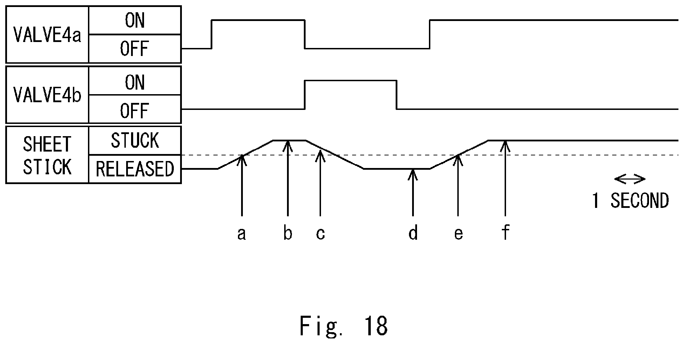

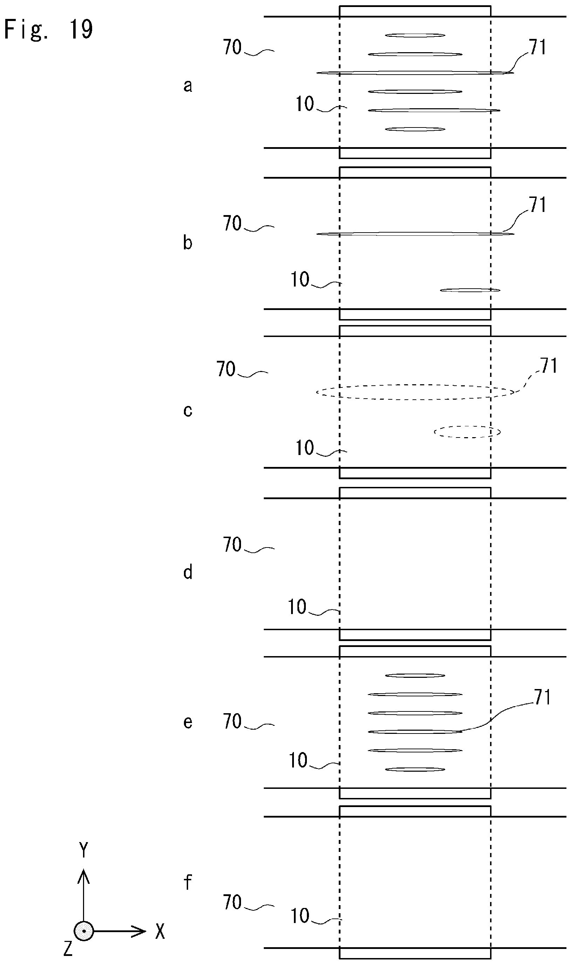

Next, description will be provided on stick operation with the sheet jig 10 of the present embodiment with reference to FIGs. 18 and 19. FIG. 18 is a time chart indicating stick operation. FIG. 19 is a view schematically illustrating states of the sheet 70 during the stick operation. FIG. 18 indicates a state of the valve 4a for sticking, a state of the valve 4b for stick releasing, and a state of sticking of the sheet 70. FIG. 19 illustrates states of the sheet 70 at timing a to timing f in FIG. 18.

First, the feeding reel 63 and the winding reel 64 are rotated with the valves 4a, 4b kept OFF, thereby the sheet 70 is moved to a predetermined position. After the sheet 70 is moved to the predetermined position, the lifting-lowering mechanism 66 lifts the sheet jig 10. Accordingly, the sheet 70 is contacted to the sheet jig 10 and lifted. After the sheet jig 70 is moved to the sticking position, the valve 4a is turned on and first sticking is to be performed. Thus, the first sticking of the sheet 70 is started (at timing a in FIG. 18). At the start timing of the first sticking, deflection of the sheet 70 is large and wrinkles 71 extending in X direction extend across the sheet jig 10, as illustrated in FIG. 19 at timing a.

When the first sticking is completed (at timing b in FIG. 18), deflection of the sheet 70 becomes small as illustrated in FIG. 19 at timing b. However, space above the uneven regions at the right and left cannot be erased completely, the wrinkles 71 are apt to remain.

Subsequently, the valve 4a is turned off and the valve 4b is turned on, thereby air is supplied to the sheet jig 10. Then, air is supplied through the first air holes 13 and the second air holes 14 and stick of the sheet 70 is released. Accordingly, the wrinkles 71 are lessened as illustrated in FIG. 19 at timing c. After air is supplied for a specific time period, the valve 4b is turned off. Then, the stick-released state is maintained with the valves 4a, 4b kept OFF. According to the above, deflection disappears almost completely as illustrated in FIG. 19 at timing d.

Subsequently, the valve 4a is turned on to perform second sticking. At the start timing of the second sticking, the sheet 70 is kept with less deflection. That is, the second sticking can be started with less deflection compared to the first sticking. Accordingly, space does not remain above the uneven regions at the right and left as illustrated in FIG. 19 at timing e. As sticking continues, wrinkles are to disappear. Thus, the sheet 70 can be stuck and fixed without wrinkles as illustrated in FIG. 19 at timing f. Accordingly, the sheet 70 can be flattened.

A manufacturing process is performed on the sheet 70 in the state that the sheet 70 is stuck to the sheet jig 10. A film-forming process to form a film on a sheet or a machining process to process a sheet may be performed as the manufacturing process. A manufacturing process other than a film-forming process and a machining process may be performed as well. A manufacturing method to perform such manufacturing process is preferable for sheet-shaped secondary cells. Further, since the above can be applied to a roll-to-roll manufacturing process, the manufacturing process can be performed continuously. Accordingly, productivity can be improved.

In the present embodiment, since sticking is performed with tensile force exerted on the sheet 70, sheet 70 can be stuck in a shorter time than the first embodiment. For example, the sticking process can be completed in about 10 seconds.

In the above, description is provided on examples of the embodiments of the present invention. Here, the present invention includes appropriate modifications as long as not imparting objects and advantages thereof. Further, the present invention is not limited to the abovementioned embodiments.

This application is based upon and claims the benefit of priority from Japanese patent application No. 2016-63451, filed on March 28, 2016, the disclosure of which is incorporated herein in its entirety by reference.

### Reference Signs List

- 2: Positioning guide
- 3: Pipe
- 4: Valve
- 5: Vacuum pump
- 6: Grip portion
- 7: Air supplying mechanism
- 8: Controller
- 10: Sheet jig
- 11: Plate
- 12: Base plate
- 13: First air hole
- 14: Second air hole
- 14a: Straight portion
- 14b: Taper portion
- 15: Air hole groove
- 17: Center placement face
- 18: Peripheral upper face
- 19: Slope face
- 20: Piping hole
- 50: Sheet
- 61: Feeding unit
- 62: Winding unit
- 63: Feeding reel
- 64: Winding reel
- 66: Lifting-lowering mechanism
- 70: Sheet
- 100: Stage

## Claims

1. A sheet jig, comprising:
a center placement face (17) on which a center region of a sheet (50) is placed as having a plurality of first air holes (13) configured to cause the center region of the sheet (50) to be stuck;
a peripheral upper face (18) formed outside the center placement face (17) at height being lower than the center placement face (17) in side view as having a plurality of second air holes (14) configured to cause a periphery region of the sheet (50) to be stuck; and
a slope face (19) formed from the center placement face (17) to the peripheral upper face (18).

2. The sheet jig according to claim 1, wherein a boundary between the peripheral upper face (18) and the slope face (19) is chamfered.

3. The sheet jig according to claim 1 or claim 2, wherein the second air hole (14) has a diameter-increasing portion at which diameter thereof increases toward the peripheral upper face (18) from the lower side in side view.

4. The sheet jig according to claim 3, wherein a boundary between the second air hole (14) and the peripheral upper face (18) is chamfered.

5. The sheet jig according to any one of claims 1 to 4, wherein the second air hole (14) is adjacent to the slope face (19).

6. A stage, comprising:
the sheet jig (10) according to any one of claims 1 to 5; and
an air discharging mechanism configured to discharge air downward from an upper face of the sheet jig (10) through the first air holes (13) and the second air holes (14).

7. A manufacturing apparatus comprising the state according to claim 6 configured to perform a manufacturing process on the sheet (70) in a state that the sheet (70) is stuck to the stage (100).

8. The manufacturing apparatus according to claim 7, wherein the manufacturing process includes at least either a film-forming process to form a film on the sheet (70) or a machining process to process the sheet (70).

9. The manufacturing apparatus according to claim 7 or claim 8, further comprising:
a pair of conveying reels including a winding reel (64) configured to wind the sheet (70) and a feeding reel (63) configured to feed the sheet (70) onto the sheet jig (10); and
an air supplying mechanism (7) configured to release stick of the sheet (70) to the stage (100) by supplying air toward an upper face of the sheet jig (10) through the first air holes (13) and the second air holes (14).

10. The manufacturing apparatus according to claim 9, further comprising:
a first valve connected to the air discharging mechanism;
a second valve connected to the air supplying mechanism (7); and
a controller (8) configured to control the air discharging mechanism to perform air discharging in a state that the pair of conveying reels are stopped and the sheet (70) is pulled in a feeding direction.

11. The manufacturing apparatus according to claim 10, wherein the controller (8) is configured to control the first valve and the second valve so that discharging with the air discharging mechanism (7), stick releasing of the sheet (70) with the air supplying mechanism, and discharging with the air discharging mechanism are performed in the order thereof.

12. A method for manufacturing a sheet-shaped secondary cell comprising a manufacturing process for the sheet-shaped secondary cell to be performed on a sheet (70) using the manufacturing apparatus according to any one of claims 7 to 11.

13. The method for manufacturing a sheet-shaped secondary cell according to claim 12, wherein the manufacturing process includes at least placing the sheet (70) as a first electrode, and layering an n-type metal oxide semiconductor layer formed of n-type metal oxide semiconductor and a charge layer formed of material including n-type metal oxide semiconductor and insulting material, on the sheet in the order thereof.
